**Europäisches Patentamt**

**European Patent Office**

**Office européen des brevets**

(19)

(11) Veröffentlichungsnummer: **0 177 717**
**B1**

(12)

# EUROPÄISCHE PATENTSCHRIFT

(45) Veröffentlichungstag der Patentschrift:
**17.05.89**

(51) Int. Cl.⁴: **H01J 37/304**, G01R 31/28

(21) Anmeldenummer: **85110382.0**

(22) Anmeldetag: **19.08.85**

(54) **Verfahren zur automatischen Positionierung einer Korpuskularsonde.**

(30) Priorität: **04.09.84 DE 3432479**

(43) Veröffentlichungstag der Anmeldung:
**16.04.86 Patentblatt 86/16**

(45) Bekanntmachung des Hinweises auf die Patenterteilung:
**17.05.89 Patentblatt 89/20**

(84) Benannte Vertragsstaaten:
**DE FR GB IT NL**

(56) Entgegenhaltungen:
EP-A- 0 054 710
EP-A- 0 104 577

PATENTS ABSTRACTS OF JAPAN, Band 4, Nr. 141, 4. Oktober 1980, Seite 21 E 28; & JP - A - 55 91 826 (FUJITSU K.K.) 11-07-1980
Idem
THE TRANSACTIONS OF THE IECE OF JAPAN, Band E 64, Nr. 5, Mai 1981, Seiten 295-301, Tokyo, JP; H. FUJIOKA u.a.: "Function testing of bipolar and MOS LSI circuits with a combined stroboscopic SEM-microcomputer system"
Idem
PROCEEDINGS OF THE MC INTERNATIONAL TEST CONFERENCE, 16.-18. Oktober 1984, Seiten 550-556, IEEE, New York, US; P. KÖLLENSPERGER u.a.: "Automated electron beam testing of VLSI circuits"

(73) Patentinhaber: **Siemens Aktiengesellschaft Berlin und München, Wittelsbacherplatz 2, D-8000 München 2(DE)**

(72) Erfinder: **Wolfgang, Eckhard, Dr., Winternitzstrasse 6, D-8000 München 83(DE)**
Erfinder: **Rummel, Peter, Dipl.-Ing., Miesbacherstrasse 94, D-8184 Festenbach(DE)**

**Beschreibung**

Die Erfindung bezieht sich auf ein Verfahren zur automatischen Positionierung einer Korpuskularsonde nach dem Oberbegriff des Anspruchs 1.

Ein solches Verfahren ist dem Fachmann aus The transactions of the IECE of Japan, Vol. E64, Nr. 5 (1981), Seiten 295 bis 301, bekannt.

Für Messungen von Spannungen und von Spannungsverläufen im Innern von integrierten Schaltungen wird eine Elektronensonde benutzt. Die Meßstellen sind dabei in der Regel metallische Leitbahnen oder Prüfflecken in der obersten Leitbahnebene. Um die Elektronensonde sicher in die Mitte der jeweiligen Leitbahn oder des jeweiligen Prüffleckens zu positionieren, ist eine automatische Positionierung der Elektronensonde wünschenswert. Die Abmessungen eines Prüffleckens oder einer Leitbahnbreite betragen heute einige µm und werden sich in Zukunft weiter verkleinern. Falls durch Instabilitäten der verwendeten Meßanordnung oder aus anderen Gründen, zum Beispiel infolge von elektrischen Feldern, die Elektronensonde veranlaßt wird, sich von der Mitte der untersuchten Leitbahn oder von der Mitte des untersuchten Prüffleckens wegzubewegen, soll dies registriert und kompensiert werden.

Die Positionierung der Elektronensonde erfolgt in Elektronenstrahl-Meßgeräten, welche in der Regel modifizierte Raster-Elektronenmikroskope sind, im sogenannten Bild-/Punktbetrieb. In diesem Bild-/Punktbetrieb wird abwechselnd der Elektronenstrahl über die Probe gerastert, wobei ein Bild erzeugt wird, und dann wieder auf eine bestimmte Meßstelle gerichtet. Dieser Vorgang, bei dem abwechselnd ein Bild erzeugt und sodann der Elektronenstrahl auf eine bestimmte Meßstelle gerichtet wird, wiederholt sich so schnell, daß die bestimmte Meßstelle auf dem Bild sichtbar ist, und daß mit Hilfe von Potentiometern, die die Spannungen für die Ablenkspulen des Raster-Elektronenmikroskops steuern, die Positionierung der Elektronenstrahlsonde so verändert werden kann, daß die bestimmte Meßstelle mit einem bestimmten Meßpunkt innerhalb der Probe übereinstimmt. Ein Elektronenstrahl- Meßgerät ist beispielsweise aus der US- Patentschrift 4277679 bekannt.

Ideal wäre es, wenn die Elektronensonde, ähnlich wie bei der gewöhnlichen Elektronenstrahl-Lithografie, die gewünschte Stelle auf dem Objekt mit hoher Genauigkeit treffen würde. Ein solches Verfahren zur Positionierung eines Elektronenstrahles ist beispielsweise aus der US-Patentschrift 3644700 bekannt. Das geht bei der Elektronenstrahl-Meßtechnik jedoch nicht, da lokale Felder - wie beispielsweise lokale Temperaturschwankungen oder lokale elektrische Felder - die genaue Position der jeweiligen Meßstelle verschoben erscheinen lassen und daher die genaue Position der jeweiligen Meßstelle nicht von vornherein genau festlegen lassen. Die lokalen Felder, die diese scheinbaren Abweichungen des Lage-Istwertes einer Meßstelle vom Lage-Sollwert dieser Meßstelle verursachen, lassen sich nicht exakt im vorhinein bestimmen und unterliegen im allgemeinen auch noch zusätzlichen zeitlichen Schwankungen während einer Messung oder (allgemeiner gesprochen) während einer Bearbeitung der Probe.

Der vorliegenden Erfindung liegt die Aufgabe zugrunde, ein Verfahren der eingangs genannten Art anzugeben, mit der die Korpuskularsonde auch dann auf einen gewünschten Punkt positioniert werden kann, wenn die Position dieses Punktes sich aufgrund von lokalen Feldern nicht von vornherein mit hoher Genauigkeit festlegen läßt.

Diese Aufgabe wird erfindungsgemäß durch ein Verfahren nach dem Anspruch 1 gelöst. Ausgestaltungen und Vorteile der Erfindung sind in den Unteransprüchen, der Beschreibung und der Zeichnung dargestellt.

Die Erfindung ist nicht auf die Verwendung einer Elektronensonde beschränkt. Zur Durchführung eines Verfahrens nach der Erfindung kann auch jede sonstige Lichtsonde beziehungsweise Ionensonde verwendet werden.

Die Erfindung ist nicht auf die Elektronenstrahl-Meßtechnik beschränkt. Die Erfindung läßt sich auch bei jeder anderen Bearbeitungsweise eines Objekts verwenden, bei der die Positionierung einer Korpuskularsonde auf einem gewünschten Bereich dadurch erschwert ist, daß die Ist-Lage dieses gewünschten Bereiches in dem entsprechenden Korpuskularmikroskop gegenüber der Soll-Lage dieses gewünschten Bereiches aufgrund von lokalen Feldern verschoben erscheint. Als lokale Felder kommen Magnetfelder, elektrische Felder, Temperaturfelder u.s.w. in Betracht. Temperaturschwankungen entstehen beispielsweise dann, wenn ein elektrischer Leiter erwärmt wird, weil in ihm ein Strom geführt wird. Magnetische Felder können beispielsweise aufgrund von Strömen entstehen. Lokale elektrische Felder spielen beispielsweise dann eine Rolle, wenn Bereiche mit unterschiedlichen elektrischen Potentialen aneinandergrenzen.

Wenn derjenige Bereich, auf dem die Korpuskularsonde positioniert werden soll, ein anderes elektrisches Potential aufweist als ein benachbarter Bereich, so läßt sich mit Hilfe des Potentialkontrastes die Korpuskularsonde in ähnlicher Weise auf dem gewünschten Bereich positionieren, wie dies im Ausführungsbeispiel der Beschreibung für eine Positonierung mit Hilfe des sogenannten Kanteneffekts angegeben ist. Die Übertragung vom Kanteneffekt auf den Potentialkontrast ist für einen Fachmann ohne erfinderisches Zutun möglich.

Wenn der Bereich, auf dem die Korpuskularsonde positioniert werden soll, etwa gleiches Potential aufweist wie seine Umgebung, so wird die Positionierung der Korpuskularsonde vorteilhafterweise mit Hilfe des Kanteneffekts durchgeführt. Dies ist insbesondere dann von Vorteil, wenn die Positionierung auf einer Leitbahn innerhalb einer integrierten Schaltung erfolgen soll, weil der Übergang von der Leitbahn zur Umgebung dieser Leitbahn, im allgemeinen eine isolierende Fläche, besonders gute Kanteneffekte zeigt. Wenn bei einem Anwendungsfall für ein Verfahren nach der Erfindung ein besonders ausgeprägter Kanteneffekt zu erwarten ist, wenn zugleich jedoch das Potential des gewünschten Bereiches, auf dem die Korpuskularsonde positioniert werden soll, verschieden ist vom Potential der Umgebung dieses gewünschten Bereiches, so wird vorteilhafterweise eine Positionierung mit Hilfe des Kanteneffekts vorgenommen, wobei zugleich der Potentialkontrast unterdrückt wird. Um das Signal, das aufgrund des Kanteneffekts erzeugt wird, optimal empfangen zu können, wird zur Unterdrückung des Potentialkontrasts bei einem Elektronenstrahl-Meßgerät an das Gegenfeld des Elektronenspektrometers eine geeignete Spannung, z.B. 0 Volt, angelegt.

In besonderen Fällen, z.B. zur Auswahl einer elektrischen Leitung aus verschiedenen benachbarten elektrischen Leitungen, kann es günstig oder erforderlich sein, das vom Poten tialkontrast herrührende Signal auszuwerten.

Die Ursache des Kanteneffekts ist in jedem Lehrbuch für Raster-Elektronenmikroskopie beschrieben. Der Kanteneffekt entsteht durch zusätzliche Sekundärelektronen-Emission an den Kanten eines Bereiches, beispielsweise an den Leitbahnflanken innerhalb einer integrierten Schaltung. An einer vorspringenden Kante bzw. an einer vorstehenden Objektstruktur tritt eine erhöhte Rückstreuung von Korpuskeln und eine erhöhte Sekundärelektronen-Ausbeute auf, da dort die Diffusionswolke stärker angeschnitten wird und da dadurch mehr rückgestreute bzw. transmittierte Korpuskeln die Probe verlassen können. Diese rückgestreuten bzw. transmittierten Korpuskeln lösen bei ihrem Austritt aus der Probe auch mehr Sekundärelektronen aus, insbesondere deshalb, weil sie Energie in der Probe verloren haben und die Oberfläche unter einem schrägen Winkel durchdringen.

Für ein Verfahren nach der Erfindung lassen sich jedoch auch andere Meßsignale verwenden, deren Ursache beispielsweise Kontrast durch Flächenneigung, Kontrast durch Abschattung, Materialkontrast oder Kontrast aufgrund von irgendwelchen sonstigen unterschiedlichen Eigenschaften von benachbarten Bereichen oder an der Grenze zwischen benachbarten Bereichen sind.

Bei der automatischen Positionierung innerhalb einer integrierten Schaltung ist es wichtig, daß die Rastergeschwindigkeit so hoch wie möglich ist, damit die Aufladung von isolierenden Gebieten unterbunden wird. Eine geeignete Energie der Primärkorpuskeln, bei der genau soviele Ladungen auf die Oberfläche auftreffen wie Ladungen diese Oberfläche verlassen, ist jedoch ebenfalls dazu geeignet, die Aufladung von isolierenden Gebieten zu vermeiden.

Der Begriff "unterschiedliche Bereiche" in Anspruch 1 drückt aus, daß diese Bereiche oder die Grenze zwischen diesen Bereichen in einem Meßsignal deutlich unterschieden werden kann bzw. können.

Zur automatischen Positionierung kann die Korpuskularsonde entlang von Linien über unterschiedliche Bereiche hinweg gerastert werden. Die Korpuskularsonde kann jedoch zu diesem Zweck auch einfach in einer solchen Weise abgelenkt werden, daß sie in unterschiedlichen Bereichen auf Punkte auftrifft, deren Abstände voneinander deutlich definiert sind. Eine solche deutliche Definition von Abständen zwischen verschiedenen Punkten ist beispielsweise mit Hilfe eines digitalen Rastergenerators möglich.

Ausführungsbeispiele der Erfindung sind in der Zeichnung dargestellt und werden im folgenden näher beschrieben.

Fig.1 zeigt eine Anordnung zur Durchführung eines Verfahrens nach der Erfindung.

Fig.2 erläutert das Positionieren einer Elektronensonde auf einer Leitbahn.

Fig.3 zeigt ein Meßsignal, das bei der Positionierung einer Elektronensonde gewonnen wird.

Fig.4 und 5 zeigen bevorzugte Ausführungsformen.

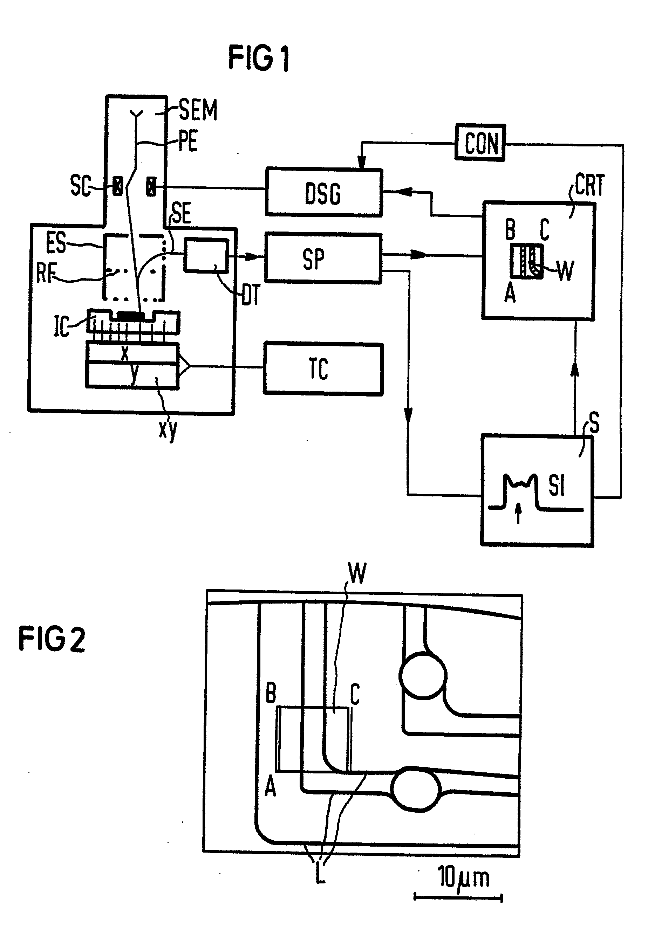

Fig.1 zeigt eine Anordnung zur Durchführung eines Verfahrens nach der Erfindung. Ein wesentlicher Bestandteil dieser Anordnung ist ein Elektronenstrahl-Meßgerät SEM, wie es beispielsweise in den US-Patentschriften 4241259 und 4277679 beschrieben worden ist. Primärelektronen PE können mit Hilfe von Rasterspulen SC abgelenkt und auf einen gewünschten Punkt innerhalb einer integrierten Schaltung IC positioniert werden. Beim Auftreffen der Primärelektronen PE werden am Auftreffpunkt innerhalb der integrierten Schaltung IC Sekundärelektronen SE ausgelöst. Ein Teil dieser Sekundärelektronen SE kann das Gegenfeld einer Gegenfeldelektrode RF überwinden, wird dabei innerhalb eines Elektronenspektrometers ES zu einem Detektor DT hin abgelenkt und in diesem Detktor DT nachgewiesen. Dabei entsteht ein Sekundärelektronen-Meßsignal. Dieses Sekundärelektronen- Meßsignal wird anschließend in einer Signalverarbeitungskette SP weiterbehandelt. Die Sekundärelektronen-Verarbeitungskette SP enthält üblicherweise einen Fotomultiplier und verschiedene nachgeschaltete Verstärker bzw. einen sogenannten 'boxcar'-Integrator, wie er beispielsweise in der US-Patentschrift 4413181 beschrieben ist. Ein Ausgangssignal der Sekundärelektronen-Meßsignal-Verarbeitungskette SP führt zum Bildschirm CRT des verwendeten Elektronenstrahl- Meßgerätes SEM. Ein Ausgangssignal der Sekundärelektronen- Meßsignal-Verarbeitungskette SP ist mit einem Graphikbildschirm S verbunden. Über ein Ausgangssignal des Bildschirms CRT wird ein digitaler Rastergenerator DSG angesteuert, der seinerseits die Rasterspulen SC mit den für eine gewünschte Ablenkung der Primärelektronen PE erforderlichen Spannungen versorgt. Über eine Tischsteuerung TC kann die Position der integrierten Schaltung IC, die fest mit einem Tisch XY verbunden ist, grob eingestellt werden.

Fig.2 erläutert ein Verfahren nach der Erfindung. Wenn die Koordinatensysteme, die die Punkte auf der Oberfläche des Tisches XY definieren, die die Punkte auf der Oberfläche der integrierten Schaltung IC definieren und die die zweidimensionale Ablenkwirkung der Ablenkeinrichtungen, die im wesentlichen aus den Rasterspulen SC bestehen, definieren, aufeinander ausgerichtet sind, kann im Prinzip jeder Punkt innerhalb der integrierten Schaltung IC automatisch mit Hilfe der Schrittmotoren des Tisches XY in eine solche Position gebracht werden, daß die Elektronensonde auf diesem Punkt auftreffen würde. Die Genauigkeit dieser Positionierung mit Hilfe der Schrittmotoren des Tisches XY liegt jedoch innerhalb einer Fläche, deren Länge und deren Breite jeweils 14 mm betragen, bei lediglich ±15 µm. Diese große Ungenauigkeit ist nicht nur dadurch bedingt, daß die Einstellmöglichkeit des Tisches XY per se so schlecht ist, sondern auch dadurch, daß am Auftreffpunkt der Elektronensonde innerhalb der integrierten Schaltung IC lokale Felder bestehen. Diese große Ungenauigkeit von ±15 µm bei der Positionierung der Elektronensonde auf einem Meßpunkt der integrierten Schaltung IC ist unzureichend, wenn man bedenkt, daß die Breite einer elektrischen Leiterbahn innerhalb einer integrierten Schaltung IC etwa 1 µm beträgt und in Zukunft noch kleiner werden wird. Um die Positionierung zu verbessern, wird mit Hilfe eines stroboskopischen Meßverfahrens ein Teil der Oberfläche der integrierten Schaltung IC auf dem Bildschirm CRT abgebildet. Ein solches stroboskopisches Meßverfahren ist beispielsweise in der US-Patentschrift 3628012 beschrieben. Das stroboskopisch aufgenommene Bild von der Oberfläche der integrierten Schaltung IC kann in einen Bildspeicher eingegeben werden. Dadurch wird sichergestellt, daß die Elektronensonde nur kurze Zeit die Oberfläche der integrierten Schaltung IC mit einem Strahl aus geladenen Teilchen belastet. Das gespeicherte Bild von der Oberfläche der integrierten Schaltung IC wird auf dem Bildschirm CRT dargestellt. Die gewünschte Meßstelle, auf der die Elektronensonde positioniert werden soll, wird mit Hilfe eines in Lage und Größe veränderbaren Fensters W so markiert, daß eine Seitenkante des Fensters W quer über einer ausgewählten Leitbahn L liegt. Diese Seitenkante des Fensters W, die quer zu einer ausgewählten Leitbahn L liegt, ist in Fig.2 die Verbindungslinie zwischen den Punkten B und C. Die Verbindungslinie zwischen den beiden Punkten A und B liegt dabei senkrecht zur Verbindungslinie zwischen den beiden Punkten B und C. Die Elektronensonde rastert mehrmals entlang den beiden Verbindungslinien zwischen den Punkten A und B bzw. B und C. Das Raster entlang der Verbindungslinie zwischen den Punkten A und B erfolgt deshalb, damit der Rauschuntergrund des Meßsignals bestimmt wird. Die ausgewählte Leitbahn L bzw. die Kanten der ausgewählten Leitbahn L liefern ein größeres Sekundärelektronensignal als das Oxid. Dies bedeutet, daß die ausgewählte Leitbahn L von der Verbindungslinie zwischen den Punkten B und C geschnitten wird. Daher wird das Verhältnis aus dem Meßsignal, das aus der Abrasterung der Verbindungslinie zwischen den Punkten B und C gewonnen wird, und dem Meßsignal, das aus der Abrasterung der Verbindungslinie zwischen den Punkten A und B gewonnen wird, gebildet. Aus diesem Verhältnis wird auf die Zahl der für eine ausreichend gute Lage-Erkennung bzw. für ein ausreichend gutes Signal-Rausch-Verhältnis notwendigen Abrasterungen entlang der Verbindungslinien zwischen den Punkten A und B bzw. B und C geschlossen.

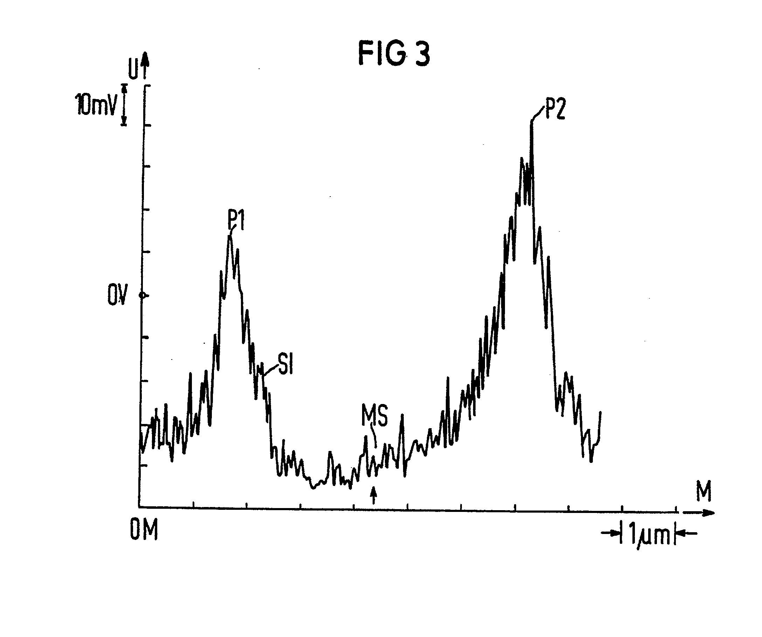

Fig.3 zeigt ein Meßsignal SI, das mit einem Verfahren nach der Erfindung mit Hilfe des sogenannten Kanteneffekts gewonnen worden ist. Dieses Meßsignal SI ist in der Meßanordnung nach Fig.1 auf dem Graphikbildschirm S dargestellt. Die Kanten der ausgewählten Leitbahn L sind durch die Spitzen P1, P2 des Meßsignals SI gekennzeichnet. Die Mitte MS der ausgewählten Leitbahn L ist in Fig.3 mit einem Pfeil angegeben. Das Ergebnis dieser Leitbahnmittensuche wird beispielsweise über den Bildschirm CRT oder über eine Rechnersteuerung CON an den digitalen Rastergenerator DSG weiter gegeben, und die Elektronensonde wird über die Ablenkspulen SC entsprechend auf die Mitte MS der ausgewählten Leitbahn L positioniert.

Wenn die Vorpositionierung mit Hilfe des Tisches XY so gut ist, daß ein Fenster W nicht mehr um eine ausgewählte Leitbahn L herum markiert werden muß, kann einfach mit Eingabe der Soll-Koordinaten eines Punktes innerhalb einer ausgewählten Leitbahn L die angegebene Prozedur ohne zusätzliche Markierung eines Fensters W ablaufen.

Das Meßsignal SI von Fig.3 wurde mit einer Elektronensonde gewonnen, die eine Pulsbreite von 5 ns und einen Sondenstrom von 2 nA aufgewiesen hat (duty cycle = 1:1000).

Die Oberfläche der integrierten Schaltung IC wurde zur Vorpositionierung auf dem Bildschirm CRT mit einer Vergrößerung von größer 1000-fach gebildet.

Um Aufladungen der isolierenden Gebiete (Oxide), die den elektrisch leitenden Gebieten benachbart sind, zu vermeiden, kann die Abrasterung zur Leitbahnmittensuche auch in Form eines T durchgeführt werden, wobei die Abrasterung zur Ermittlung des Rauschsignals auf einer Leitbahn L in Richtung dieser Leitbahn L und nicht auf dem Oxid, wie in Fig.2 dargestellt, durchgeführt wird.

Wichtig für ein Verfahren nach der Erfindung ist, daß zwei getrennte Signale gewonnen werden, von denen ein Signal entweder nur das Rauschen oder nur das Leitbahnsignal enthält und von denen das andere Signal sowohl das Rauschen als auch das Leitbahnsignal enthält. Noch allgemeiner formuliert, müssen die beiden Signale so gestaltet sein, daß das Rauschsignal und das Nutzsignal voneinander getrennt werden kön nen. Dabei ist als Randbedingung anzusehen, daß Meßpunkte ausreichend nahe an der Grenze zwischen zwei unterschiedlichen Bereichen angeordnet sind, um die Lage eines bestimmten Meßpunktes innerhalb eines gewünschten Bereiches definieren zu können.

Wenn das Ergebnis der Leitbahnmittensuche auf dem Graphikbildschirm S ausgegeben wird, besteht die Möglichkeit einer manuellen Korrektur durch Verschieben des Pfeiles, der die Leitbahnmitte MS angibt.

Während oder nach einer Messung kann die Drift der Elektronensonde durch Wiederholen der Leitbahnmittensuche und durch Differenzbildung der verschiedenen Mittenwerte MS bestimmt und gegebenenfalls durch Nachführen der Elektronensonde kompensiert werden.

Durch zyklische Ermittlung der Leitbahnmitte MS während der Messung und durch Rückführung des Lage-Istwertes auf die Sondenpositionierung kann eine automatische Leitbahnmitten- Regelung durchgeführt werden. Zu diesem Zweck kann ein Ausgangssignal vom Graphikbildschirm S direkt an den digitalen Rastergenerator DSG gegeben werden. Als Lage-Sollwert dienen bei einer solchen automatischen Leitbahnmitten-Regelung z.B. die zu Beginn der Messung ermittelten Leitbahnmitten- Koordinaten.

Im folgenden wird ein konkretes Unterprogramm zur Leitbahnmittensuche angegeben. Für einen Fachmann ist es dabei ohne weiteres möglich, ein solches Programm dann entsprechend abzuwandeln, wenn er eine Korpuskularsonde nicht auf die Mitte, sondern auf einen anderen bestimmten Bereich innerhalb einer Fläche, die nicht unbedingt eine Leitbahn sein muß, positionieren will. Wichtig ist nur, daß die räumliche Lage des bestimmten Bereiches sich aufgrund einer signifikanten Struktur eines Meßsignals festlegen läßt, und daß diese räumliche Lage dieses bestimmten Bereiches aufgrund von lokalen Feldern in einer scheinbar verschobenen Lage zu erwarten ist.

Mit Hilfe des Unterprogrammes LEITSU, das in der Rechnersteuerung CON ablaufen kann, lassen sich die Koordinaten der Mitte einer Leitbahn L ermitteln. Dies geschieht mit Hilfe eines Spannungssignals, das durch eine Abrasterung quer über die Leitbahn L gewonnen wird. Diese Abrasterung quer über die Leitbahn L wird im konkreten Beispiel so ausgeführt, daß eine Hälfte der Rasterkurve parallel zur Leitbahn L, die andere Hälfte der Rasterkurve senkrecht zur Leitbahn L verläuft. Wenn die Rasterkurve anders verlaufen würde, müßte das Unterprogramm LEITSU entsprechend verändert werden.

Das gemessene Spannungssignal besteht im konkreten Beispiel also während einer Hälfte der Abrasterung aus einem reinen Rauschsignal, während der anderen Hälfte der Abrasterung aus einer Überlagerung aus einem Rauschsignal und einem Nutzsignal. Das gemessene Spannungssignal weist während der gesamten Abrasterung einen Gleichspannungsanteil auf.

Aufgrund des Potentialkontrasts, der sich ergibt, wenn die Leitbahn L ein anderes Potential als ihre Umgebung aufweist, oder aufgrund des Kanteneffekts weist der gemessene Signalverlauf im Bereich der Leitbahnkanten einen Anstieg bzw. einen Abfall auf, wodurch sich die Lage der Leitbahn L und die Mitte der Leitbahn L ermitteln lassen. Da eine einmalige Abrasterung quer zur Leitbahn L möglicherweise ein zu schwaches Nutzsignal liefert, wird die Abrasterung quer zur Leitbahn L so oft wiederholt, bis aufgrund einer statistischen Auswertung sämtlicher erzielter Meßergebnisse ein befriedigendes Endresultat vorliegt. Das Unterprogramm LEITSU soll also zuerst die Zahl SCANWI der Abrasterungen quer zur Leitbahn L ermitteln, die nötig ist, um ein ausreichendes Resultat der Leitbahnmittensuche zu erhalten, und soll sodann die Koordinaten der Leitbahnmitte angeben. Zu diesem Zweck enthält das Unterprogramm LEITSU als Eingaben die Zahl RASTER der Rasterpunkte, die im Bildspeicher pro Koordinatenachse vorgesehen sind, die Länge LSCAN der Abrasterungskurve quer zur Leitbahn L, wobei diese Länge LSCAN als eine bestimmte Anzahl von Rasterpunkten ausgedrückt wird, das Meßfeld SCAN, das jedem Rasterpunkt entlang der Abrasterungskurve das zugehörige Meßsignal zuordnet, und die Leitbahnbreite LEITB, die beispielsweise in μm angegeben werden kann.

Das Signal-/Rauschspannungs-Verhältnis des von seinem Gleichspannungsanteil befreiten Meßsignals ist bestimmend dafür, wie oft eine Abrasterung quer zur Leitbahn L vorgenommen werden muß, damit ein ausreichendes Resultat erzielt wird. Wenn die Meßergebnisse mehrerer Abrasterungen, die jeweils entlang derselben Abrasterungskurve quer zur Leitbahn L vorgenommen werden, aufsummiert werden, ist in der Summe der Meßergebnisse nicht nur das Nutzsignal verbessert, sondern auch das Rauschsignal vermindert. Das Rauschsignal ist nämlich eine statistisch schwankende Größe und wird daher bei beliebig vielen Messungen beliebig klein. Geht man von einem bestimmten, beispielsweise empirisch ermittelten Soll-Wert QSOLL des Signal-/Rauschspannungs-Verhältnisses bei einem über mehrere Abrasterungen aufsummierten Meßergebnis aus, so erhält man die Zahl SCANWI der Abrasterungen, die für ein ausreichendes Resultat notwendig sind, aus der Beziehung:

$$Q_{SOLL} = SR \cdot \sqrt{SCANWI + 1} \cdot \sqrt{\frac{LSCANH}{LBREIT}} \qquad (1)$$

mit

SCANWI : Zahl der Wiederholungen von Abrasterungen,
SR : Signal-/Rauschspannungs-Verhältnis bei einer einzelnen Abrasterung,
LSCANH : halbe Länge einer Abrasterungskurve, ausgedrückt in Rasterpunkten,
LBREIT : Breite der Leitbahn L, ausgedrückt in Rasterpunkten,

$$\sqrt{\frac{LSCANH}{LBREIT}}.$$

Korrekturfaktor, der die unerwünschte Abhängigkeit des Signal-/Rauschspannungs-Verhältnisses SR von der Größe der Leitbahnbreite im Verhältnis zur Länge einer Abrasterungskurve ausgleicht.

Das Signal-/Rauschspannungsverhältnis SR bei einer einzelnen Abrasterung wird weiter unten definiert werden.

Durch Umformung ergibt sich aus Gleichung (1):

$$SCANWI = \frac{Q_{SOLL}^2}{SR^2} \cdot \frac{LBREIT}{LSCANH} - 1 \qquad (2)$$

Zur Ermittlung des Signal-/Rauschspannungs-Verhältnisses SR bei einer einzelnen Abrasterung muß das bei einer einzelnen Abrasterung gewonnene Meßsignal um seinen Gleichspannungsanteil vermindert werden. Weil die Abrasterungskurve so verläuft, daß eine Hälfte der Abrasterungskurve parallel zur Leitbahn L und daß die andere Hälfte der Abrasterungskurve quer zur Leitbahn L verläuft, muß sodann untersucht werden, in welcher der beiden Hälften der Abrasterungskurve sich das Nutzsignal befindet. Da das Nutzsignal sowohl positiv als auch negativ sein kann, müssen vier mögliche verschiedene Fälle in Betracht gezogen werden, die sich daraus ergeben, daß nicht bekannt ist, in welcher der beiden Hälften der Abrasterungskurve das Nutzsignal gewon nen wird, und ob das Nutzsignal dabei positiv oder negativ ist.

Ein Entscheidungskriterium dafür, in welcher der beiden Hälften der Abrasterungskurve das Nutzsignal gewonnen wird, stellt der Vergleich der Standardabweichungen der Meßergebnisse der beiden Hälften der Abrasterungskurve dar. Der kleinere Wert der Standardabweichungen gehört dabei zu derjenigen Hälfte der Abrasterungskurve, in der nur ein reines Rauschsignal gewonnen wird, Zur Berechnung der Standardabweichung bedient man sich des Unterprogrammes SUBROUTINE SIGMA der Library MATH (Library MATH, mathematische FORTRAN- SUBROUTINEN, Beschreibung, P71100-U0001-X-X-35), das zugleich auch den Mittelwert der zu den einzelnen Hälten der Abrasterungskurve gehörenden Meßwerte berechnet. Damit erhält man also pro Hälfte der Abrasterungskurve die jeweils zugehörende Standardabweichung S1 bzw. S2 und den jeweils zugehörenden Mittelwert MW1 bzw. MW2. Daraus ergeben sich dann mit Hilfe der folgenden Gleichungen der Gleichspannungsanteil MW des Meßsignals, der Effektivwert EFFW1 des um den Gleichspannungsanteil MW verminderten reinen Rauschsignals und der Effektivwert EFFW2 des ebenfalls um den Gleichspannungsanteil MW verminderten Meßsignals derjenigen Hälfte der Abrasterungskurve, die das Nutzsignal enthält:

$$EFFW1 = S1 \quad mit \quad S1 < S2 \qquad (3)$$

$$EFFW2 = \sqrt{(MW2 - MW1)^2 + S2^2} \qquad (4)$$

$$MW = MW1 \qquad (5)$$

Der Mittelwert MW1 des reinen Rauschsignals ist also gleich dem Gleichspannungsanteil MW des Meßsignals. Die Standardabweichung S1 des reinen Rauschsignals ist kleiner als die Standardabweichung S2 des mit dem Nutzsignal behafteten Meßsignals.

Aus den Gleichungen (3), (4), (5) ergibt sich nun mit Hilfe der Gleichung (2) die Zahl SCANWI der Wiederholungen von Abrasterungen, die für ein ausreichendes Meßresultat erforderlich sind.

Zur Berechnung der Leitbahnmitte werden zunächst die Werte des Meßfeldes SCAN um den Gleichspannungsanteil MW vermindert. Dadurch erhält man einen mittelwertfreien Verlauf des Meßsignals. Das so gewonnene Meßsignal, das in einem konkreten Ausführungsbeispiel als Zahlenfolge von maximal 512 aufeinanderfolgenden Zahlenwerten zur Verfügung steht, ist jedoch immer noch mit starkem Rauschen überlagert. Da womöglich das Signal-/Rauschspannungs-Verhältnis SR ziemlich klein ist, ist eine Vorverarbeitung des Meßsignals zweckmäßig, die zweierlei leistet: 1. Eine Unterdrückung bzw. eine Verringerung des Rauschpegels und 2. eine Verbesserung des Nutzsignals.

Zu diesem Zweck wird zweckmäßig das Meßsignal geglättet. Dies geschieht beispielsweise mit Hilfe des in der oben angegebenen Library MATH auf Seite 166 angegebenen Unterprogrammes SUBROUTINE GLEX. Bei diesem Unterprogramm handelt es sich um eine exponentielle Glättung einer Zahlenfolge, deren Güte sich mittels einer Konstanten G variieren läßt. Als weitere Möglichkeit zur Glättung des Meßsignals kommt eventuell eine einfache lineare Glättung in Frage, z.B. durch Mittelwertbildung über eine bestimmte Anzahl von Punkten. Diese Mittelwertbildung müßte dann möglicherweise wiederholt angewendet werden.

Als vorzügliche Methode zur Glättung des Meßsignals empfiehlt sich eine Art "Korrelation", da hierbei auch die Breite der Leitbahn L berücksichtigt wird. Dabei werden, beginnend beim ersten Wert des Meßfeldes SCAN, eine bestimmte Anzahl von Zahlenwerten dieses Meßfeldes SCAN aufsummiert und wird diese Summe dem ersten Wert des Meßfeldes SCAN zugeordnet. Als bestimmte Anzahl von Zahlenwerten, über die aufsummiert wird, kann beispielweise diejenige Zahl herangezogen werden, die sich ergibt, wenn die Leitbahnbreite in Rasterpunkte umgerechnet wird. Als "Fensterbreite" der "Korrelation" wird also die in Rasterpunkten ausgedrückte Leitbahnbreite gewählt. Jedem Zahlenwert des Meßfeldes SCAN wird also eine Summe zugeordnet, die sich ergibt, wenn eine bestimmte Anzahl von Zahlenwerten des Meßfeldes SCAN aufsummiert wird, wobei diese Summe in einer festen Relation zu demjenigen Zahlenwert des Meßfeldes SCAN stehen muß, dem sie schließlich zugeordnet wird. Beispielsweise kann bei jedem Zahlenwert einer Zahlenwertfolge die dem vorhergehenden Zahlenwert zugeordnete Summe um den ältesten Zahlenwert vermindert und um einen neuen Zahlenwert der Zahlenwertfolge vergrößert und schließlich dem betreffenden Zahlenwert zugeordnet werden. Im Idealfall, d.h. bei einem Rechteck-Meßsignal und bei einer Fensterbreite, die gleich der Breite des gemessenen Rechtecksignals ist, erhält man bei diesem Verfahren ein gleichschenkeliges Dreieck, sofern das gemessene Rechtecksignal genügend Abstand sowohl zum Anfang als auch zum Ende des Meßsignals aufweist. Wie die Experimente zeigen, liefert diese Methode der Korrelation bei einer mit starkem Rauschen überlagerten Rechteckfunktion zufriedenstellende Ergebnisse, denn bei dieser Methode wird nicht nur das Rauschen verringert, sondern wird auch das Nutzsignal um ein Vielfaches verstärkt. Wenn die Fensterbreite nicht genau mit der Breite des Nutzsignals übereinstimmt, was in der Praxis oft der Fall ist, erhält man mit Hilfe der Methode der Korrelation eine Dreiecksform, die oben mehr oder weniger abgeflacht ist. Mit einem solchen Signalverlauf, der in einem Feld SUM von Variablen abgespeichert werden kann, läßt sich nun auf ziemlich einfache Weise auf den Mittelpunkt der Leitbahn L schließen, nämlich durch Bestimmung der Schwerpunktskoordinate der sich ergebenden Signalfläche. Nach Vorzeichenänderung aller negativen Werte des Feldes SUM werden alle Werte, die unterhalb einer bestimmten Schwelle liegen, eliminiert, d.h. gleich Null gesetzt. Die Schwerpunktskoordinate, ausgedrückt als Funktion des laufenden Index des Feldes, erhält man nun durch Aufsummieren aller Produkte aus Amplituden $U_i$ des Nutzsignals und laufendem Index $i$ und nach Division dieser Summe durch die Amplitudensumme:

$$i_s = \frac{\sum_i U_i \cdot i}{\sum_i U_i} \qquad (6)$$

Da dabei ziemlich große Zahlenwerte vorkommen, müssen INTEGER*4-Variable verwendet werden.

Wenn das Korrelationsfeld SUM so gebildet worden ist, daß jedem Wert des Meßfeldes SCAN diejenige Summe zugeordnet worden ist, die man erhält, wenn man diesen Meßwert als ersten Summanden nimmt und sodann soviele folgende Zahlenwerte dazuaddiert, wieviele in der Fensterbreite der Korrelation Platz haben bzw. wieviele Rasterpunkte der Leitbahnbreite entsprechen, liegt die Schwerpunktskoordinate $i_s$ etwa an einer Kante der Leitbahn L. Aus der Schwerpunktskoordinate $i_s$ ergibt sich sodann die Koordinate der Leitbahnmitte $i_m$:

$$i_m = i_s + \frac{LBREIT}{2} \qquad (7)$$

Die Zuordnung dieser Leitbahnmitte $i_m$ zum Mittelpunkt der jeweiligen Abrasterungskurve ergibt sich durch einfache Umrechnung.

Das oben angegebene Signal-/Rauschspannungs-Verhältnis SR ist nach der folgenden Gleichung definiert:

$$SR = \frac{EFFW2}{EFFW1} - 1 \qquad (8)$$

Das Signal-/Rauschspannungs-Verhältnis SR ist also der um 1 verminderte Quotient aus dem Effektivwert EFFW2 des nutzsignalbehafteten Meßsignals und dem Effektivwert EFFW1 des reinen Rauschsignals, wobei beide Effektivwerte um den Gleichspannungsanteil EW vermindert sind. Das Signal-/Rauschspannungs-Verhältnis SR läßt Rückschlüsse auf die zu erwartende Genauigkeit des Resultats zu. Ist das Signal-/Rausch-Spannungs-Verhältnis SR größer als 1,5, so beträgt die Abweichung des Ressultats vom wahren Wert maximal (in seltenen Fällen) ±3 Rasterpunkte. Bei einer angenommenen Leitbahnbreite von 60 Rasterpunkten bzw. 2 μm ist dies ein Fehler von maximal ±10% der Leitbahnbreite. Die Genauigkeit des Resultats verbessert oder verschlechtert sich nicht wesentlich bei Verkleinerung bzw. Vergrößerung der Leitbahnbreite. Auch die Form des Meßsignals spielt für die Genauigkeit des Resultats keine Rolle, sofern es keine größeren Asymmetrien aufweist.

Wenn die Breite der Leitbahn L mit 60 Rasterpunkten angegeben wird, können für die Länge der Abrasterungskurve beispielsweise 256 Rasterpunkte verwendet werden.

Bei größeren Asymmetrien des Nutzsignals liefert die Leitbahnmitten-Bestimmung mittels der Schwerpunktmethode unter Umständen keine besonders guten Ergebnisse. Sofern es sich um immer wieder gleiche Asymmetrien handelt, kann das Meßsignal durch einen konstanten Korrekturwert berichtigt werden. Falls unsystematische, unregelmäßig auftretende Asymmetrien vorliegen, kann das geglättete Signal beispielsweise ab einem bestimmten Wert abgeschnitten werden. Durch Abflachen wird dabei das Nutzsignal seiner Asymmetrie beraubt, womit allerdings ein Teil der im Signal enthaltenen Information verlorengeht.

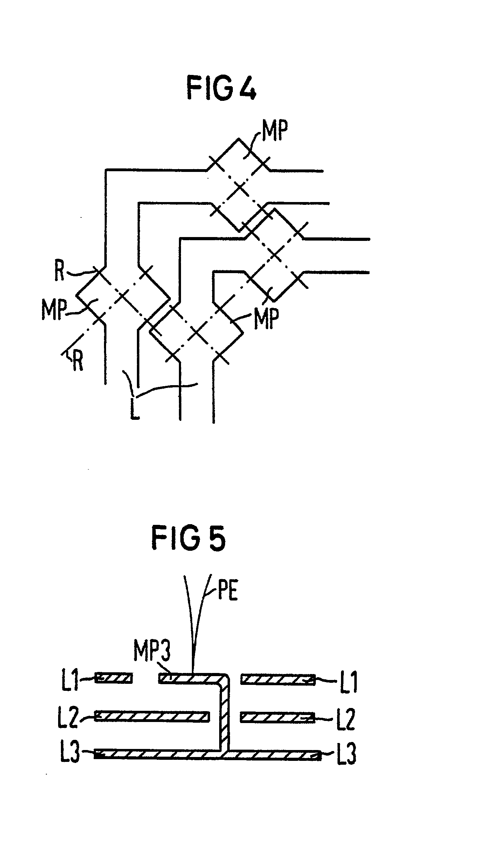

Fig. 4 zeigt eine bevorzugte Ausführungsform von Prüfflecken MP. Damit interne Prüfflecken MP bei der automatischen Positionierung besser erkannt werden, sollen diese Prüfflecken MP die Form eines Quadrats (Raute, Rechteck, Kreis, u.s.w.) aufweisen, wobei zwei Spitzen dieses Quadrats jeweils auf der Mitte der Leitbahn L angeordnet sind und wobei die Seitenlänge des Quadrats größer ist als die Breite der Leitbahn L. Die Quadrate der Prüfflecken MP können zur automatischen Positionierung einer Korpuskularsonde parallel zu den Seiten des Quadrats abgetastet werden. Die Abtastkurven R liegen dann schräg zur Mittenlinie der Leitbahn L. Die besondere Form der Prüfflecken MP ermöglicht eine effektive Verbreiterung der Prüfflecken MP und ein rasches und sicheres Auffinden der beiden Koordinaten des Meßpunkts MP, d.h. sowohl der x-Koordinate als auch der y-Koordinate des Meßpunkts MP.

Fig. 5 zeigt eine weitere bevorzugte Ausführungsform für einen Prüfflecken MP3. Ween eine Leitbahn L3 sich unterhalb von zwei anderen Leitbahnebenen mit den Leitbahnen L1, L2 befindet, was z.B. in einer integrierten Schaltung der Fall sein kann, die in verschiedenen Schichten übereinander aufgebaut ist, kann für einen Schaltungsknoten, der auf der Leitbahn L3 angeordnet ist, ein Kontaktflecken MP3 in einer Metallisierungsebene geschaffen werden, zu der mit der Elek trodensonde PE noch Zugang besteht. Der Kontaktflecken MP3 ist dabei mit dem Schaltungsknoten, der auf der Leitbahn L3 angeordnet ist, leitend verbunden.

## Patentansprüche

1. Verfahren zur automatischen Positionierung einer Korpuskularsonde (PE) innerhalb eines bestimmten Bereichs einer Probe (IC), bei dem die Korpuskularsonde (PE) in einer ersten Abtastrichtung (B–C) über den bestimmten Bereich (MP) derart abgelenkt wird, daß ein durch Nachweis der auf der Probe (IC) ausgelösten Sekundärkorpuskeln (SE) erzeugtes erstes Meßsignal sowohl einen Rauschanteil als auch einen den bestimmten Bereich charakterisierenden Nutzsignalanteil enthält, dadurch gekennzeichnet,
    – daß die Korpuskularsonde (PE) in einer zweiten Abtastrichtung (A–B) abgelenkt wird, wobei die zweite Abtastrichtung (A–B) so gewählt ist, daß ein durch Nachweis der ausgelösten Sekundärkorpuskeln (SE) erzeugtes zweites Meßsignal nur einen Rauschanteil enthält,
    – daß ein Signal–Rauschspannungsverhältnis aus dem ersten und zweiten Meßsignal ermittelt wird,
    – daß die Anzahl der zur Positionierung der Korpuskularsonde (PE) notwendigen Abtastungen in der ersten Abtastrichtung (B–C) aus dem Signal–Rauschspannungsverhältnis ermittelt wird,
    – daß die entsprechende Anzahl der Abtastungen vorgenommen wird,
    – daß die Lage des bestimmten Bereichs (MP) aus einem bei den Abtastungen gewonnenen dritten Meßsignal (SI) bestimmt wird, und
    – daß die Korpuskularsonde (PE) innerhalb des bestimmten Bereichs (MP) positioniert wird.

2. Verfahren nach Anspruch 1, dadurch gekennzeichnet, daß die erste und die zweite Abtastrichtung (A–B, B–C) einen Winkel von 90° einschließen.

3. Verfahren nach Anspruch 1 oder 2, dadurch gekennzeichnet, da die zweite Abtastrichtung (A–B) parallel zu einer Leiterbahn (L) verläuft.

4. Verfahren nach Anspruch 3, dadurch gekennzeichnet, daß die Korpuskularsonde (PE) außerhalb der Leiterbahn (L) in der zweiten Abtastrichtung (A–B) abgelenkt wird.

5. Verfahren nach Anspruch 3, dadurch gekennzeichnet, daß die Korpuskularsonde (PE) auf der Leiterbahn (L) in der zweiten Abtastrichtung (A–B) abgelenkt wird.

6. Verfahren nach einem der Ansprüche 1 bis 5, dadurch gekennzeichnet, daß die Meßsignale durch Nachweis der auf der Probe (IC) ausgelösten Sekundärelektronen (SE) erzeugt werden.

7. Verfahren nach Anspruch 6, dadurch gekennzeichnet, daß ein Potentialkontrastsignal als Meßsignal verwendet wird.

8. Verfahren nach einem der Ansprüche 1 bis 7, dadurch gekennzeichnet, daß die Korpuskularsonde (PE) mit Hilfe von Schrittmotoren innerhalb des bestimmten Bereichs (MP) positioniert wird.

9. Verfahren nach einem der Ansprüche 1 bis 7, dadurch gekennzeichnet, daß die Korpuskularsonde (PE) mit Hilfe eines Lasermeßsystems innerhalb des bestimmten Bereichs (MP) positioniert wird.

**EP 0 177 717 B1**

### Claims

1. Process for the automatic positioning of a corpuscular probe (PE) within a specified region of a specimen (IC), in which the corpuscular probe (PE) is deflected in a first scanning direction (B–C) over the specified region (MP) in such a way that a first measuring signal, which is generated by the detection of the secondary corpuscles (SE) released on the specimen (IC), contains both a noise component and also a useful signal component typifying the specified region, characterized in that the corpuscular probe (PE) is deflected in a second scanning direction (A–B), the second scanning direction (A–B) being chosen in such a way that a second measuring signal generated by the detection of the secondary corpuscles (SE) which are released contains only a noise component, in that a signal-to-noise voltage ratio is determined from the first and second measuring signal, in that the number of the scannings required for positioning the corpuscular probe (PE) is determined in the first scanning direction (B–C) from the signal-to-noise voltage ratio, in that the corresponding number of scannings is undertaken, in that the location of the specified region (MP) is determined from a third measuring signal (SI) obtained with the scannings, and in that the corpuscular probe (PE) is positioned within the specified region (MP).

2. Process according to Claim 1, characterized in that the first and the second scanning direction (A–B, B–C) enclose an angle of 90°.

3. Process according to Claim 1 or 2, characterized in that the second scanning direction (A–B) extends parallel to a printed conductor (L).

4. Process according to Claim 3, characterized in that the corpuscular probe (PE) is deflected outside the printed conductor (L) in the second scanning direction (A–B).

5. Process according to Claim 3, characterized in that the corpuscular probe (PE) is deflected on the printed conductor (L) in the second scanning direction (A–B).

6. Process according to one of Claims 1 to 5, characterized in that the measuring signals are generated by the detection of the secondary electrons (SE) released on the specimen (IC).

7. Process according to Claim 6, characterized in that a potential contrast signal is used as measuring signal.

8. Process according to one of Claims 1 to 7, characterized in that the corpuscular probe (PE) is positioned within the specified region (MP) with the aid of stepping motors.

9. Process according to one of Claims 1 to 7, chracterized in that the corpuscular probe (PE) is positioned within the specified region (MP) with the aid of a laser measuring system.

### Revendications

1. Procédé pour le positionnement automatique d'une sonde corpusculaire (PE) dans une zone déterminée d'un échantillon (IC), selon lequel la sonde corpusculaire (PE) es déviée dans une première direction de balayage (B–C) sur la zone déterminée (MP), de manière qu'un premier signal de mesure, généré par la détection des corpuscules secondaires (SE) dont l'émission a été provoquée sur l'échantillon (IC), contienne à la fois une fraction de bruit et une fraction de signal utile caractérisant la zone déterminée, caractérisé en ce que
– on dévie la sonde corpusculaire (PE) dans une deuxième direction de balayage (A–B) qui est choisie de manière qu'un deuxième signal de mesure, généré par la détection des corpuscules secondaires (SE) dont l'émission a été provoquée, contienne seulement une fraction de bruit,
– on détermine, à partir du premier et du deuxième signal de mesure, un rapport tension de signal/tension de bruit,
– on détermine, à partir du rapport tension de signal/tension de bruit, le nombre des balayages dans la première direction de balayage (B–C) nécessaires
– on détermine, à partir du rapport tension de signal/tension de bruit, le nombre des balayages dans la première direction de balayage (B–C) nécessaires pour le positionnement de la sonde corpusculaire (PE),
– on effectue le nombre correspondant de balayages,
– on établit l'emplacement de la zone déterminée (MP) à partir d'un troisième signal de mesure (SI) obtenu lors des balayages et
– on positionne la sonde corpusculaire (PE) dans la zone déterminée (MP).

2. Procédé selon la revendication 1, caractérisé en ce que la première et la deuxième direction de balayage (A–B, B–C) renferment un angle de 90°.

3. Procédé selon la revendication 1 ou 2, caractérisé en ce que la deuxième direction de balayage (A–B) est parallèle à une piste conductive (L).

4. Procédé selon la revendication 3, caractérisé en ce que l'on dévie la sonde corpusculaire (PE) en dehors de la piste conductive (L) dans la deuxième direction de balayage (A–B).

5. Procédé selon la revendication 3, caractérisé en ce que l'on dévie la sonde corpusculaire (PE) sur la piste conductive (L) dans la deuxième direction de balayage (A–B).

6. Procédé selon une des revendications 1 à 5, caractérisé en ce que l'on génère les signaux de mesure par détection des électrons secondaires (SE) dont l'émission a été provoquée sur l'échantillon (IC).

7. Procédé selon la revendication 6, caractérisé en ce que l'on utilise un signal de contraste de potentiel en tant que signal de mesure.

8. Procédé selon un des revendications 1 à 7, caractérisé en ce que l'on positionne la sonde corpusculaire (PE) dans la zone déterminée (MP) à l'aide de moteurs pas-à-pas.

9. Procédé selon une des revendications 1 à 7, caractérisé en ce que l'on positionne la sonde corpusculaire (PE) dans la zone déterminée (MP) à l'aide d'un système de mesure laser.

# FIG 1

# FIG 2

10μm

FIG 3

# FIG 4

# FIG 5